Europäisches Patentamt

European Patent Office

Office européen des brevets

(11) Veröffentlichungsnummer: **0 429 763 A1**

## (12) EUROPÄISCHE PATENTANMELDUNG

(21) Anmeldenummer: **90115880.8**

(22) Anmeldetag: **20.08.90**

(51) Int. Cl.5: **H03K 3/02, H03K 17/975**

(30) Priorität: **12.10.89 DE 3934158**

(43) Veröffentlichungstag der Anmeldung:
**05.06.91 Patentblatt 91/23**

(84) Benannte Vertragsstaaten:
**AT DE ES GB GR IT Patentblatt 1**

(71) Anmelder: **Bosch-Siemens Hausgeräte GmbH
Hochstrasse 17
W-8000 München 80(DE)**

(72) Erfinder: **Beifuss, Wolfgang, Dipl.-Ing.
Eglseer Strasse 5
W-8224 Chieming(DE)**
Erfinder: **Waigand, Helmut, Dipl.-Ing.
Traunstrasse 18d
W-8225 Traunreut(DE)**

(54) **Digitaler kapazitiver Impulsgenerator.**

(57) Der Impulsgenerator ist ausgestaltet als kapazitiver Bitgenerator mit einem Rotor (3) und einem Stator (2), zwischen denen ein Dielektrikum (4) angeordnet ist, wobei der Rotor (3) als eine mit metallischen Elementen ausgestattete, axial antreibbare Scheibe angeordnet ist und der Stator (2), der elektrostatisch und flächenhaft voneinander isolierte, metallisch beschichtete Sektoren (10, 12, 13) besitzt, als Signalein- und Signalauskoppelelektrode ausgebildet ist.

Fig.1a

Fig.1b

EP 0 429 763 A1

## DIGITALER KAPAZITIVER IMPULSGENERATOR.

Die Erfindung bezieht sich auf einen Impulsgenerator für ein mit elektronischen Steuer- und Anzeigeeinrichtungen ausgestattetes Haushaltgerät, insb. für eine durch nur ein Bedienelement betätigbare, in Haushaltgeräte befindlichen Steuerung, wobei dem Impulsgenerator ein Impulsformer und eine Drehrichtungserkennung nachgeordnet sind.

Aus der DE-PS 2 540 486 ist es bekannt, Frequenzteiler und Zählvorrichtungen einer elektronischen Uhr über eine Anzeigekorrektureinrichtung mit Hilfe eines Impulsgenerators zu betätigen. Der Impulsgenerator ist dabei (Fig. 3 obengenannter Druckschrift) vorwiegend durch mechanische Elemente realisiert. Darüber hinaus ist es bekannt, Impulsgeneratoren mit Wandlerelementen auszustatten, die auf dem Piezoeffekt, optischen Lichtschranken oder elektromagnetischen Effekten beruhen.

Ein Bitgenerator gibt je nach Drehrichtung zwei zeitlich versetzte Impulsfolgen ab, aus denen sowohl die Drehrichtung links, rechts sowie die Drehgeschwindigkeit eindeutig abgeleitet werden kann. Bekannte Bitgeneratoren mit Schleifkontakten besitzen einen Kontaktverschleiß, sind nicht entprellt und durch die Kontaktmaterialien im Temperaturbereich begrenzt. Bitgeneratoren mit aktiven Kontaktgebern sind in der Lebensdauer durch das aktive Element und/oder im Temperaturbereich eingeschränkt.

Aufgabe der Erfindung ist es, einen weitgehend verschleißfreien und für extreme Temperaturbereiche einsetzbaren Impulsgenerator, der als Bitgenerator verwendet wird, zu schaffen, wobei die Lebensdauer des Bitgenerators nicht von der Lebensdauer eines aktiven Kontaktgebers abhängig sein soll.

Die erfindungsgemäße Anordnung zur Lösung dieser Aufgabe ist dadurch gekennzeichnet, daß der Impulsgenerator als ein in kapazitiver Struktur aufgebauter Bitgenerator ausgeführt ist und daß der kapazitive Bitgenerator aus einem Rotor und einem Stator, zwischen denen ein Dielektrikum angeordnet ist, besteht, wobei der Rotor als eine mit metallischen Elementen ausgestattete axialantreibbare Scheibe angeordnet ist und der Stator, der elektrostatisch und flächenhaft voneinander isolierte metallisch beschichtete Sektoren besitzt, als Signalein- und Signalauskoppelelektrode ausgebildet ist.

Eine weitere vorteilhafte Ausgestaltung der Erfindung ist dadurch gekennzeichnet, daß das elektrisch wirksame Statorgebildet als Kreisfläche ausgeführt ist und aus drei elektrostatisch und flächenhaft voneinander isolierten metallisch beschichteten Sektoren besteht. Weitere vorteilhafte Ausgestaltungen der Erfindung sind in den Unteransprüchen enthalten.

Ein Ausführungsbeispiel nach der Erfindung ist im folgenden anhand der Zeichnung näher beschrieben. Es zeigt

Fig. 1a eine Gesamtansicht des Impulsgenerators,

Fig. 1b eine kapazitive Anordnung gemäß Fig. 1a,

Fig. 2a eine Statorausführung,

Fig. 2b eine Rotorausführung,

Fig. 3 ein Kapazitätsersatzschaltbild,

Fig. 4 eine elektronische Auswerteschaltung,

Fig. 5 eine Signalausgangsfolge für Rechtsdrehung,

Fig. 6 eine Signalausgangsfolge für Linksdrehung,

Fig. 7 ein Positionsfeld für Rotor-Stator-Anordnung.

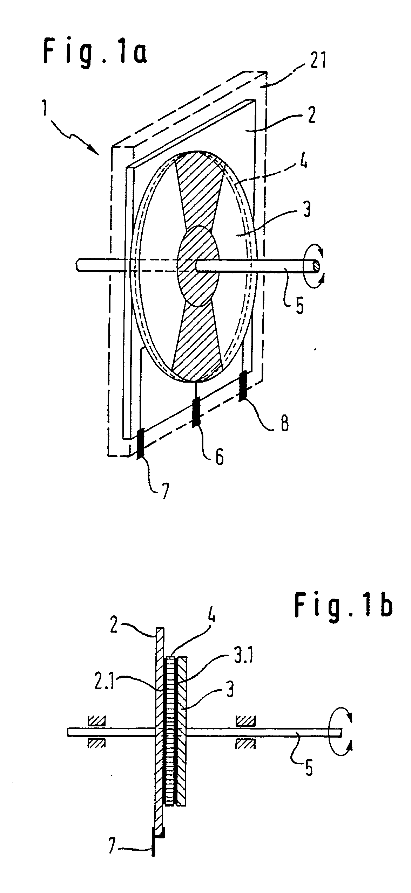

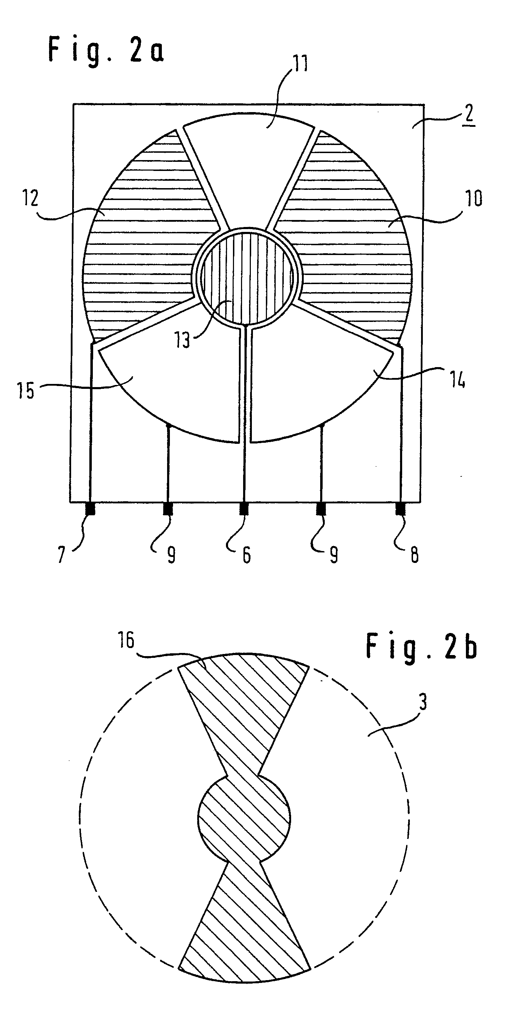

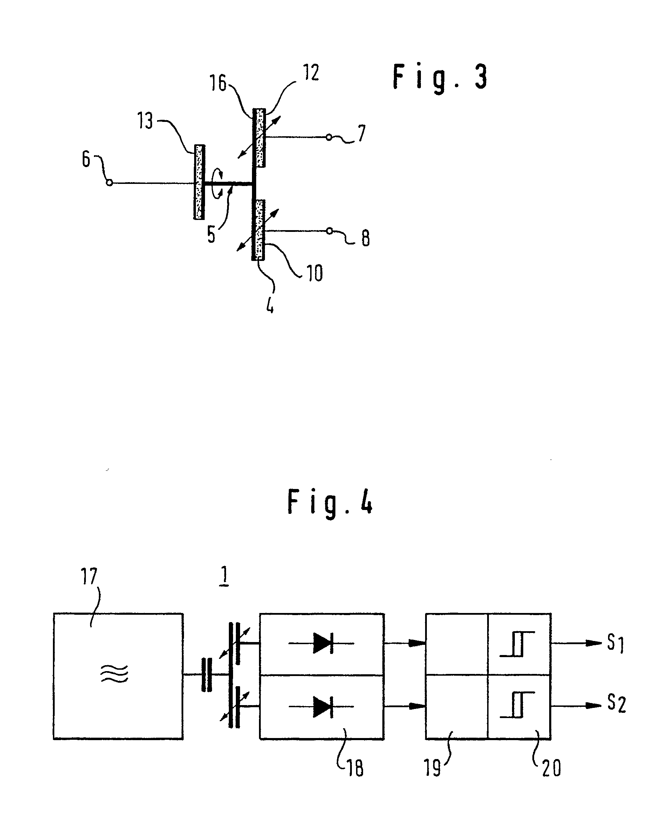

Gemäß Fig. 1a ist ein Impulsgenerator 1, der als Bitgenerator arbeitet, in Gesamtansicht dargestellt. Der Impulsgenerator 1 besteht aus einem Stator 2, einem Rotor 3, einem zwischen beiden gelegenen Dielektrikum 4, einer Drehachse 5, einem HF-Eingang 6, aus einem Impulsausgang 7, einem Impulsausgang 8 und einer metallischen Abschirmung 21. Fig. 1b zeigt einen Impulsgenerator 1 mit seinen kapazitiven Anordnungen. Durch das Dielektrikum 4 voneinander getrennt ist der Stator 2 und der Rotor 3 erkennbar. Der Stator 2 besitzt eine metallische Schicht 2.1, der Rotor 3 eine metallische Schicht 3.1. Mittels der Drehachse 5, auf der der Rotor 3 befestigt ist, kann der Rotor gegenüber dem Stator verschiedene Positionen einnehmen, die sowohl fest positionierbar sind als auch kontiunuierlich durch Drehung herbeigeführt werden können. Gemäß Fig. 2a ist eine Statorausführung dargestellt. Auf dem Stator 2 ist ein elektrisch wirksames Statorgebilde angeordnet, das als Kreisfläche ausgeführt ist und aus drei elektrostatisch und flächenhaft voneinander isolierten, metallisch beschichteten Sektoren besteht. Ein erster metallisch beschichteter Sektor 10 ist bei Richtungsverfolgung entgegen dem Uhrzeigersinn durch einen nicht metallischen Sektor 11 von einem mit dem metallischen Sektor 10 -identischen Sektor 12 getrennt. Ein zentraler metallischer Sektor 13 ist als Koppelkondensatorelektrode vorgesehen und wird über den Eingang 6 mit HF-Signalen gespeist. Bei gleichbleibender Richtungsverfolgung schließt sich dem metallsichen Sektor 12 ein nicht metallisches Sektorfeld an, das gemäß Fig. 2a aus zwei nicht-metallischen Sektoren 14, 15 besteht. Die Sektoren 10, 12 stellen Elektroden eines Signalkondensators dar und sind mit den Ausgängen 8, 7 verbunden. Die Anschlüsse 9 werden zur Erdung der Sektoren 11, 14, 15 benutzt. Über die Anschlüsse 9 sind auch andere Po tentiale anlegbar, wenn das für den jeweiligen Bitgenerator vorteilhaft ist. Gemäß Fig. 2b ist der Rotor 3 mit einem metallischen Flügel 16 dargestellt. Der Rotor 3 wird axial mechanisch oder von Hand angetrieben. Seine Drehachse liegt zentral und ist durch das Dielektrikum 4 und die Koppelkondensatorelektrode 13 des Stators 2 geführt. Der Rotor 3 kann ein Keramikgrundkörper sein, auf den der metallische Rotorflügel 16 aufgebracht ist, beispielsweise durch Bedampfen oder Siebdruck oder andere Beschichtungsverfahren. Der Rotorflügel 16 besitzt einen Kreisflächengrundkörper, der dem zentralen metallischen Sektor 13 des Stators 2 entspricht. Diesem Kreisflächengrundkörper sind zwei $\pi/4$-Sektorflächen aufgesetzt. Gemäß Fig. 3 ergibt sich nach den Figuren 2a, b ein Kondensatorersatzschaltbild. Der auf der Achse 5 drehbar gelagerte Rotor 3, der auch auf den metallischen Rotorflügel 16 reduziert sein kann, bildet mit dem zentralen metallischen Sektor 13 einen Einkoppelkondensator, mit dem metallisch beschichteten Sektor 12 einen ersten variablen Signalkondensator und mit dem metallisch beschichteten Sektor 10 einen zweiten variablen Signalkondensator. Dabei wird über dem Eingang 6 an den Einkoppelkondensator ein HF-Signal angelegt. Durch den metallischen Rotorflügel 16 ergibt sich entsprechend der Rotorposition für die metallisch beschichteten Sektoren 12, 10 eine variable Kapazität. Dementsprechend ergibt sich an den Ausgängen 7, 8 ein variables Ausgangssignal. Zur Verbesserung der Bitgeneratoranordnung wird zwischen Stator 2 und Rotor 3 ein Dielektrikum 4 angeordnet.

Aus $C = \frac{Q}{U} = \frac{D}{E} \cdot \frac{F}{a} = \epsilon \frac{F}{a}$ mit $\epsilon = \epsilon_0 \cdot \epsilon_{rel}$ folgt:

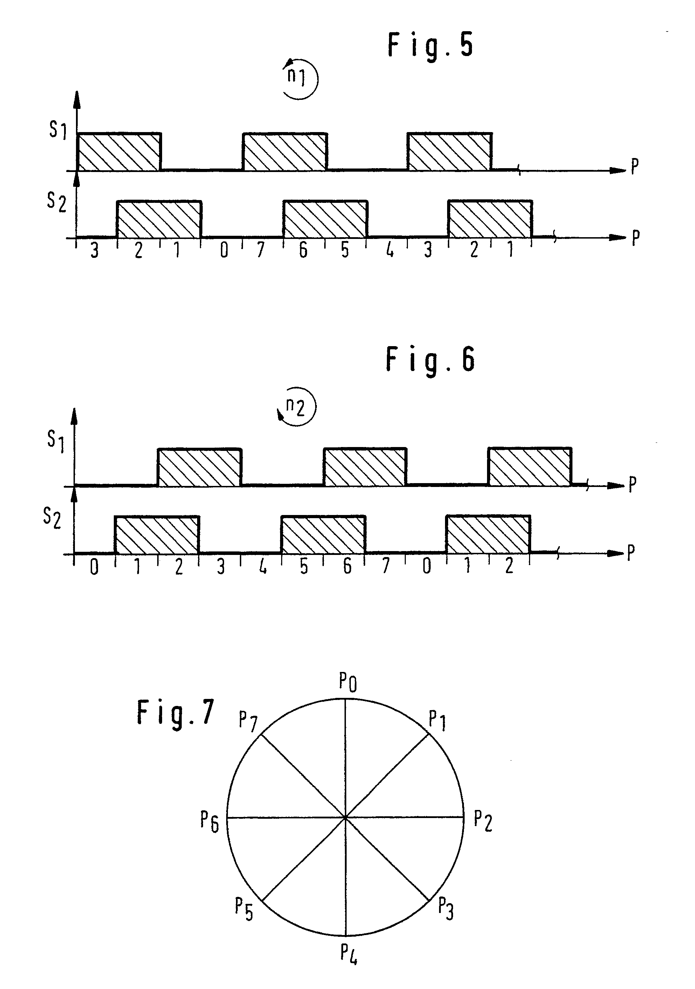

Die veränderliche Kapazität des Bitgenerators ist besonders groß, wenn die Kondensatorfläch F möglichst groß ist, ein möglichst hohes $\epsilon$ vorhanden ist und ein möglichst kleiner Plattenabstand der Kondensatoranordnung gewahrt wird. Die Fläche F des Kondensators ist über den Rotorflügel 16 variabl und größenmäßig begrenzt, $\epsilon$ gesamt wird über das hohe $\epsilon$ rel. der Keramik maximiert und der Abstand A zwischen den Kondensatorplatten kann so klein gewählt werden, wie die Schichtstärke des Dielektrikums 4 und die konstruktive Gesamtanordnung zuläßt. Als Dielektrikum 4 bietet sich eine Bariumtitanat-Keramik ($BaTiO_9$) mit einer relativen Dielektrizitätskonstante von rel = 120 und einer maximal zulässigen Temperaturbelastung von 1500° C an. Durch den Einsatz von keramischen Materialien für den Rotor 3 und den Stator 2 sowie für das Dielektrikum 4 kann der kapazitive Bitgenerator für extreme Temperaturen ausgelegt werden. Zur elektrostatischen Abschirmung ist der ganze Bitgenerator metallisch umhüllt. Eine Rasterung der Drehachse 5 wird, falls erforderlich, mit kleinen Permanentmagneten und gegenüberliegenden Weicheisentei len vorgenommen. Die Achse wird verschleißfrei in einem Metallgleitlager oder einer Metallkeramiklagerstelle geführt. Figur 4 zeigt eine elektronische Anordnung, die zur Anwendung und Auswertung des Bitgenerators notwendig ist. Die Schaltungsanordnung besteht aus einem HF-Generator 17, der auf den HF-Eingang des Bitgenerators 1 geschaltet ist. Die Impulsausgänge 7,8 des Bitgenerators 1 werden auf eine Gleichrichterschaltung 18 geführt, deren Ausgangssignale über einen Tiefpass 19 mit einer Schwellwertschaltung 20 verbunden sind. Die Schwellwertschaltung 20 stellt an den Ausgängen S1, S2 Impulsfolgen zur Verfügung. Diese Impulsfolgen sind gemäß Fig. 5, 6 mit der Drehrichtungsinformation ausgestattet. Dabei wurde vorausgesetzt, daß der Rotorflügel 16 8 Positionen einnehmen kann, die Positionen 0 bis 7, die rastbar und durch kontunuierliche Links-Rechts-Drehung eingenommen werden können. Fig. 7 verdeutlicht die Positionen, die der Rotorflügel 16 einnehmen kann, jeweils als Mittenlage. Bezieht man diese Rotorpositionen auf die Statoranordnung gemäß Fig. 2a, so gelangt man für Rechtslauf zu den Impulsfolgen gemäß Fig. 5, bei Linslauf zu den Impulsfolgen gemäß Fig. 6. Die Folgen S1 (P) und S2 (P) sind jeweils um $\pi/2$ phasenverschoben Für Rechtslauf des Rotorflügels 16 eilt S1 der Folge S2 um $\pi/2$ voraus, für Linkslauf des Rotorflügels 16 eilt S1 der Folge S2 um $\pi/2$ nach Die Folge S1 entspricht dem Ausgang 7, die Fogle S2 entspricht dem Ausgang 8. Betrachtet man Position 0 Rechtslauf, bezogen auf Fig. 2a, dann sind beide Folgen gleich 0, für Position 1 besitzt die Folge S2 den Wert C0 entsprechend 1, die Folge S2 = 0. Für Position 2 gilt S1 = S2 = C0 entsprechend 1 usw. Damit entsteht ein Bitgenerator der für Rechts- und Linsklauf verschiedene Impulsfolgen S1, S2 abgibt und zur Informationsverarbeitung bei elektronischen Schaltungen angewendet werden kann. Solche Digitaleingaben sind für Herdsteuerungen und elektronische Uhren anwendbar.

## Ansprüche

1. Impulsgenerator für ein mit elektronischen Steuer- und Anzeigeeinrichtungen ausgestattetes Hausgerät, insb. für eine durch nur ein Bedienelement betätigbare im Haushaltgerät befindlichen Steuerung, wobei dem Impulsgenerator ein Impulsformer und eine Drehrichtungserkennung nachgeordnet sind, **dadurch gekennzeichnet,** daß der Impulsgenerator (1) als ein in kapazitiver Struktur aufgebauter Bitgenerator ausgeführt ist und daß der kapazitive Bitgenerator aus einem Rotor (3) und einem Stator (2), zwischen denen ein Dielektrikum (4) angeordnet ist, besteht, wobei der Rotor (3) als eine mit metallischen Elementen ausgestattete, axial antreibbare Scheibe angeordnet ist und der Stator (2), der elektrostatisch und flächenhaft voneinander isolierte, metallisch beschichtete Sektoren (10, 12, 13) besitzt, als Signalein- und Signalauskoppelelektrode ausgebildet ist.

2. Impulsgenerator nach Anspruch 1, dadurch gekennzeichnet, daß das elektrisch wirksame Statorgebilde als Kreisfläche ausgeführt ist und aus drei elektrostatisch und flächenhaft voneinander isolierten, metallisch beschichteten Sektoren (10, 12, 13) besteht.

3. Impulsgenerator nach Anspruch 1, dadurch gekennzeichnet, daß eine als Koppelkondensatorelektrode ausgebildete Kreisfläche einen inneren Sektor (13) bildet, wobei der Radius des Innenkreises dieses Sektors sich zum Durchmesser des Statorradius 1 : 4 verhält.

4. Impulsgenerator nach Anspruch 1, 3, dadurch gekennzeichnet, daß in der Kreisfläche des Stators (2), vermindert um die Innenkreisfläche, zwei voneinander flächenhaft und elektrostatisch getrennte, mit einem Öffnungswinkel von $\pi/2$ ausgelegte Sektoren (10, 12) als Signalkondensatorelektrodenflächen angeordnet sind.

5. Impulsgenerator nach Anspruch 1, 3 und 4, dadurch gekennzeichnet, daß die Signalkondensatorelektrodenflächen symetisch zu einem Statordurchmesser liegen und durch zwei geerdete Sektorflächen, die die Öffnungswinkel von $\pi/4$ und $3/4\pi$ besitzen, flächenhaft und elektrostatisch voneinander getrennt sind.

6. Impulsgenerator nach Anspruch 1 und 5, dadurch gekennzeichnet, daß die geerdete Sektorfläche mit dem Öffnungswinkel von $3/4\pi$ in zwei Sektorflächen (14, 15) von je $3/8\pi$ Öffnungswinkel geteilt ist.

7. Impulsgenerator nach Anspruch 1, dadurch gekennzeichnet, daß der Stator (2) einen Keramikgrundkörper besitzt, auf den die Signalkondensatorelektrodenflächen aufgedampft sind.

8. Impulsgenerator nach Anspruch 1, dadurch gekennzeichnet, daß der Stator (2) einen Keramikgrundkörper besitzt, der mit den Signalkondensatorelektrodenflächen beschichtet ist.

9. Impulsgenerator nach Anspruch 1, dadurch gekennzeichnet, daß der Stator (2) einen nicht-leitenden Kunstharzkörper besitzt, auf den die Signalkondensatorelektrodenflächen aufgebracht sind.

10. Impulsgenerator nach Anspruch 1, dadurch gekennzeichnet, daß der Rotorflügel (16) aus zwei auf einer den Innenkreis des Stators (2) entsprechenden Innenkreisfläche aufgesetzten $\pi/4$-Sektorflächen besteht.

11. Impulsgenerator nach Anspruch 1, dadurch gekennzeichnet, daß der Rotor (3), insb. die als Rotorflügel (16) ausgebildete Übertragungskondensatorelektrodenfläche, gleiche Materialeigenschaften wie der Stator (2) besitzt.

12. Impulsgenerator nach Anspruch 1, dadurch gekennzeichnet, daß das zwischen Rotor (3) nach dem Stator (2) angeordnete Dielektrikum (4) aus einer dünnen Keramikscheibe, beispielsweise Bariumtitanat besteht.

13. Impulsgenerator nach Anspruch 1, dadurch gekennzeichnet, daß zur elektrostatischen Abschirmung der Bitgenerator metallisch umhüllt ist.

# Fig.1a

# Fig.1b

# Fig. 2a

# Fig. 2b

# Fig. 3

# Fig. 4

# Fig.5

# Fig.6

# Fig.7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 729 728 (E.V. HARDWAY) <br> * ganzes Dokument * <br> --- | 1 | H 03 K 3/02 <br> H 03 K 17/975 |
| A | DE-A-2 851 723 (MIELE & CIE GMBH) <br> * ganzes Dokument * <br> --- | 1 | |
| A | US-A-4 158 216 (J.E. BIGELOW) <br> * Figuren 1,2,3; Spalte 2, Zeile 29 - Spalte 4, Zeile 23 * <br> --- | 1 | |
| A | GB-A-2 050 621 (GENERAL ELECTRIC COMPANY) <br> * Figuren 1-4; Seite 1, Zeile 107 - Seite 4, Zeile 103 * <br> ----- | 1 | |

**RECHERCHIERTE SACHGEBIETE (Int. Cl.5)**

H 03 K 3/02
H 03 K 3/64
H 03 K 17/96
H 03 K 17/975

Der vorliegende Recherchenbericht wurde für alle Patentansprüche erstellt

| Recherchenort | Abschlußdatum der Recherche | Prüfer |
|---|---|---|
| BERLIN | 06-03-1991 | TAYLOR P I |